# EUROPEAN PATENT SPECIFICATION

(11) **EP 3 168 575 B1**
(45) Date of publication and mention of the grant of the patent: **26.12.2018**
(21) Application number: 16197838.2
(22) Date of filing: 08.11.2016
(51) Int. Cl.: G01D 5/14, G01D 11/24, G01D 11/30, G05G 1/08, H03K 17/97

(54) **OPERATION DEVICE AND MUSIC REPRODUCING DEVICE**
BETRIEBSVORRICHTUNG UND MUSIKWIEDERGABEVORRICHTUNG
DISPOSITIF DE COMMANDE ET DISPOSITIF DE REPRODUCTION DE MUSIQUE

(30) Priority: 11.11.2015 JP 2015221343
(43) Date of publication of application: 17.05.2017
(73) Proprietor: Onkyo Corporation, Osaka 572-0028 (JP)
(72) Inventor: YOSHIDA, Makoto, Osaka, Osaka 572-0028 (JP); TAKESHIMA, Yoshitada, Osaka, Osaka 572-0028 (JP); MORITA, Mikio, Osaka, Osaka 572-0028 (JP); UMEZU, Norio, Osaka, Osaka 572-0028 (JP)
(74) Representative: Horn Kleimann Waitzhofer Patentanwälte PartG mbB

(56) References cited:
- CN-Y- 201 378 263
- JP-A- H11 288 322
- JP-A- 2003 262 065
- JP-A- 2004 241 333
- US-A1- 2009 231 168

## Description

### TECHNICAL FIELD

The present invention relates to an operation device that is for adjusting quantities and a music reproducing device that includes the operation device.

### BACKGROUND ART

In an operation device that is for adjusting quantities such as volume, there is an operation device using a rotary encoder. The rotary encoder can detect rotary displacement (for example, see patent literature 1.). An operation knob that includes an operation tab and a rotary axis that extends vertically against the operation tab is used as an object to be rotated.
CN 201378263 Y describes an operation device comprising an operation knob and a discharged section, wherein the discharged section is separate by a predetermined distance from and opposed to a tip of a rotary shaft of the operation knob. The rotary shaft is electrically connected to the discharged section by means of a spring.

### PRIOR ART DOCUMENT

### PATENT LITERATURE

PATENT LITERATURE 1: JP 2013-221921 A

### SUMMARY OF THE INVENTION

### PROBLEM TO BE RESOLVED BY THE INVENTION

In case that the operation knob is made of a metal, the operation knob floats electrically and electrical charge is stored in the operation knob. When stored electrical charge amount exceeds allowed amount, electrical charge is discharged. To identify current route of discharged electrical charge is difficult. For this reason, there is a problem that malfunction and noise occur when current flows in a part of an electrical circuit unintentionally.

As measure to solve the above, generally, fixed part and movable part (the operation knob) are bound by a ground line and movable part in which range is limited is ground. However, in case that the operation knob rotates without limitation, the ground line cannot be bound to the operation knob. As another method, it is thought that a plate spring is contacted to a rotor (the operation knob). However, there is a case where bug of noise, discomfort of feeling, and wear occur by friction of the plate spring and the rotor. Further, there is a danger that short-circuit is caused by metal powders that are shaved by wear contact a substrate.

It is an object of the present invention to ground an operation knob without touching a plate spring to the operation knob.

### MEANS FOR SOLVING THE PROBLEM

An operation device of a first invention including: an operation knob made by a metal that has an operation tab, a rotary axis that extends vertically against the operation tab, wherein the operation knob is insulated electrically; and a discharged section made by a metal that is separate against and opposed to a tip of the rotary axis among a predetermined distance in an axial direction of the rotary axis.

In the present invention, a discharged section made by a metal that is separate against and opposed to a tip of a rotary axis among a predetermined distance in an axial direction of the rotary axis of an operation knob is provided. Therefore, the operation knob can be ground without contacting a plate spring to the operation knob because discharging from the tip of the rotary axis to the discharged section occurs if the discharged section is connected to a standard potential.

The operation device of a second invention is the operation device of the first invention, wherein a corner part of the tip of the rotary axis is tapered toward the operation tab.

In the present invention, the corner part of the tip of the rotary axis is tapered toward the operation tab. In other words, in the tip part of the rotary axis, the sectional shape in the axial direction is trapezoid. In the operation knob that is charged, an electric field gathers on two positions of the corner parts when it is seen sectionally in the axis direction. However, the corner part of the tip of the rotary axis is tapered toward the operation tab and the interval between the two corner parts is small. Thus, a discharged position is targeted easily by tapering the corner part of the tip of the rotary axis toward the operation tab and making the corner parts approach each other. Further, the rotary axis is inserted into a rotary encoder (a bearing) easily.

The operation device of a third invention is the operation device of the first invention, wherein the corner part of the tip of the rotary axis is right angle.

The operation device of a fourth invention is the operation device of any one of the first to third inventions, the operation device further including: a fitting member that fixes parts to an enclosure, and wherein the discharged section is a part of the fitting member.

In the present invention, the discharged section is a part of a fitting member. For this reason, a new member does not need to be added for ground of the operation knob.

The operation device of a fifth invention is the operation device of the fourth invention, wherein the enclosure has a side face and a rear face orthogonal to the side face, the operation tab exposes from the side face, the rotary axis extends parallel against the rear face, and the fitting member is a tabular member and has two fitting sections that are separate from each other in a longitudinal direction of the side face, a connecting section that connects the two fitting sections and orthogonal to the two fitting sections, and an extending section that connects the connecting section and the discharged section and is orthogonal to the connecting section and the discharged section.

The operation device of a sixth invention is the operation device of any one of the first to the fifth inventions, the operation device further including: a rotary encoder in which the rotary axis is inserted into its hollow shaft.

The operation device of a seventh invention is the operation device of any one of the first to the sixth inventions, wherein the discharged section is connected to a standard potential.

The operation device of an eighth invention is the operation device of any one of the first to the seventh inventions, wherein in the axial direction of the rotary axis, the tip of the rotary axis and the discharged section are separate among distance of 0.25 times as long as the axis diameter of the rotary axis.

The operation device of a ninth invention is the operation device of any one of the first to the eighth inventions, wherein a protruding section that projects against the tip of the rotary axis is provided in the discharged section.

In the present invention, a protruding section that projects against the tip of the rotary axis is provided in the discharged section. For this reason, the electric field intensity gathers on the protruding section and targeting of a discharging position is further easy.

A music reproducing device of a tenth invention including: the operation device of any one of the first to the eighth inventions, wherein the operation knob is a volume knob for adjusting volume.

### EFFECT OF THE INVENTION

According to the present invention, an operation knob can be ground without contacting a plate spring to the operation knob.

### BRIEF DESCRIPTION OF THE DRAWINGS

Fig. 1 is a perspective view illustrating the appearance of a digital audio player according to an embodiment of the present invention.
Fig. 2 is an enlarged view near a volume knob.
Fig. 3 is a sectional view near the volume knob.
Fig. 4 is a schematic diagram illustrating the volume knob, a rotary encoder, and a discharged section.
Fig. 5 is a diagram illustrating the result of a discharging test by an electromagnetic field simulator.
Fig. 6 is a diagram illustrating a simulation result in case where a separate distance between the tip of the rotary axis and the discharged section is two times as long as the axis diameter of the rotary axis.
Fig. 7 is a diagram illustrating a simulation result in case where a separate distance between the tip of the rotary axis and the discharged section is one time as long as the axis diameter of the rotary axis.
Fig. 8 is a diagram illustrating a simulation result in case where a separate distance between the tip of the rotary axis and the discharged section is 0.5 times as long as the axis diameter of the rotary axis.
Fig. 9 is a diagram illustrating a simulation result in case where a separate distance between the tip of the rotary axis and the discharged section is 0.25 times as long as the axis diameter of the rotary axis.
Fig. 10 is a diagram illustrating a simulation result in case where a sectional shape of a tip part of the rotary axis in the axis direction of the rotary axis is triangle.
Fig. 11 is a diagram illustrating a simulation result in case where a sectional shape of the tip part of the rotary axis in the axis direction is substantially semicircle.
Fig. 12 is a diagram illustrating a simulation result in case where a corner part of the tip of the rotary axis is right angle.
Fig. 13 is a diagram illustrating a simulation result in case where the corner part of the tip of the rotary axis is tapered toward an operation tab.
Fig. 14 is an enlarged view near tip of the rotary axis and the discharged section.
Fig. 15 is a diagram illustrating a simulation result in case where a protruding section is provided in the discharged section.

### DESCRIPTION OF THE EMBODIMENTS

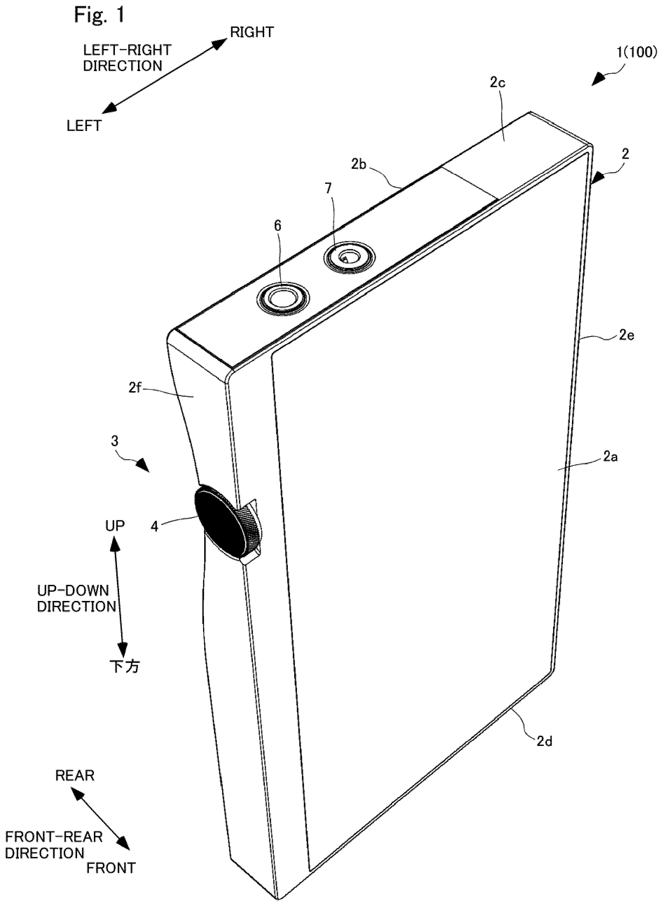

An embodiment of the present invention is described below. Fig. 1 is a perspective view illustrating the appearance of a digital audio player (hereinafter, referred as to "DAP") according to an embodiment of the present invention. Each direction illustrated in the drawings is described as left-right direction, up-down direction, or front-rear direction. The DAP 1 (music reproducing device) includes an enclosure 2, and a volume knob 3. The enclosure 2 is almost rectangular parallelepiped and accommodates substrates and ICs inside. The enclosure 2 has a front face 2a, a rear face 2b, a top face 2c, a bottom face 2d, a right side face 2e, and a left side face 2f. A display that displays a playing screen exposes from the front face 2a. A headphone jack 6 for unbalanced and a headphone jack 7 for balanced expose from the top face 2c. The volume knob 3 exposes from the left side face 2f.

### (First embodiment)

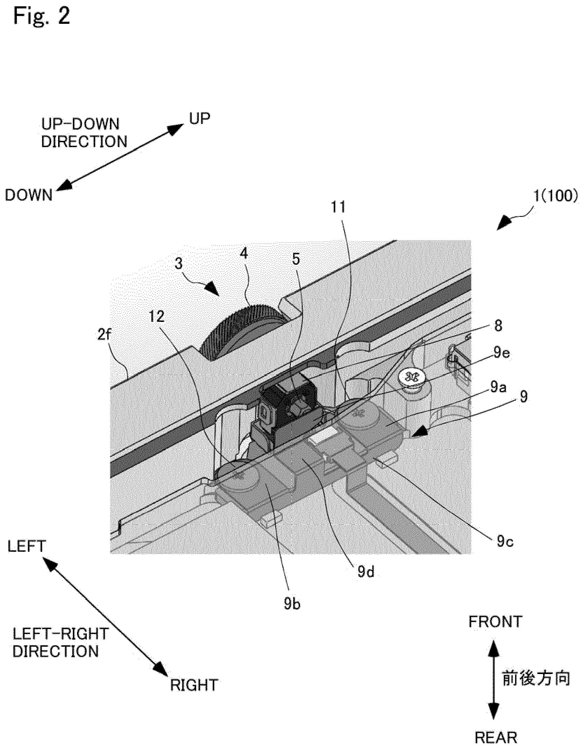

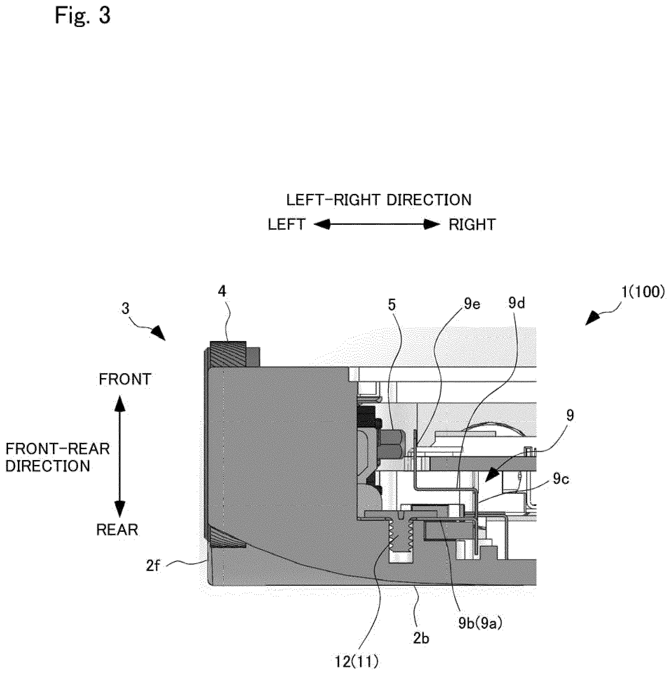

Fig. 2 is an enlarged view near the volume knob. Fig. 3 is a sectional view near the volume knob. As illustrated in Fig. 2 and Fig. 3, the DAP 1 further includes a rotary encoder 8 and a fitting member 9. An operation apparatus 100 includes at least the volume knob 3, the rotary encoder 8, and a discharged section 9e. The volume knob 3 (an operation knob) is for adjusting volume. The volume knob 3 is made of a metal. Further, the volume knob 3 is a T-shape in side view. The volume knob 3 can rotate to clockwise direction and counterclockwise direction without limitation. The volume knob 3 has a disk-shaped operation tab 4 and a rotary axis 5. The operation tab 4 is exposed from the left side face 2f of the enclosure 2. A user can adjust volume of music that the DAP1 plays by rotating the operation tab 4.

The rotary axis 5 extends vertically against the operation tab 4. The rotary axis 5 extends parallel against the rear face 2b from the left side face 2f. In other words, the rotary axis 5 extends from left to right (in the left-right direction). Herein, the rear face 2b is orthogonal to the left face 2f. Further, the corner part of the tip of the rotary axis 5 is chamfered and tapered toward the operation tab 4. In other words, in the tip part of the rotary axis 5, the sectional shape in the axial direction (left-right direction) is trapezoid. Further, in the rotary axis 5, the sectional shape in the direction (front-rear direction) orthogonal to the axial direction (left-right direction) of the rotary axis 5 is regular hexagonal.

The rotary encoder 8 is provided so that its hollow shaft is opposed to the enclosure 2. Herein, the rotary axis 5 is inserted into the hollow shaft of the rotary encoder 8. Therefore, the axial direction of the hollow shaft and the axial direction of the rotary axis 5 are the same direction (left-right direction). The fitting member 9 fixes parts to the enclosure 2. The fitting member 9 is tabular and made of a metal. The fitting member 9 has fitting sections 9a and 9b, a connecting section 9c, an extending section 9d and the discharged section 9e. Each of the fitting sections 9a and 9b has a screw hole. Each of the fitting sections 9a and 9b is U-shaped part that is opposed to the enclosure 2. The fitting section 9a and the fitting section 9b are separate among a predetermined distance in the longitudinal direction (up-down direction) of the right side face 2e and the left side face 2f. The connecting section 9c extends toward up-side direction and is a part that connects the fitting section 9a and the fitting section 9b. The connecting section 9c is orthogonal to the fitting sections 9a and 9b.

The discharged section 9e is a part that is separate against and opposed to tip of the rotary axis 5 among a predetermined distance in the axial direction (left-right direction) of the rotary axis 5. Further, the discharged section 9e is a vertical part against the axial direction (left-right direction) of the rotary axis 5. Concretely, in the axial direction (left-right direction) of the rotary axis 5, the tip of the rotary axis 5 and the discharged section 9e are separate among distance of 0.25 times as long as the axis diameter of the rotary axis 5. For example, in case that the axis diameter of the rotary axis 5 is 2.0 mm, the tip of the rotary axis 5 and the discharged section 9e are separate among 0.5 mm (= 2.0 mm × 0.25). The extending section 9d is a part that connects the connecting section 9c and the discharged section 9e. The extending section 9d is orthogonal to the connecting section 9c and the discharged section 9e. Parts are fitted on the enclosure 2 by the fitting member 9 by inserting screws 11 and 12 into the screw holes of the fitting sections 9a and 9b and screwing the screws 11 and 12 to the enclosure 2. Further, the fitting member 9 (the discharged section 9e) is connected to the standard potential.

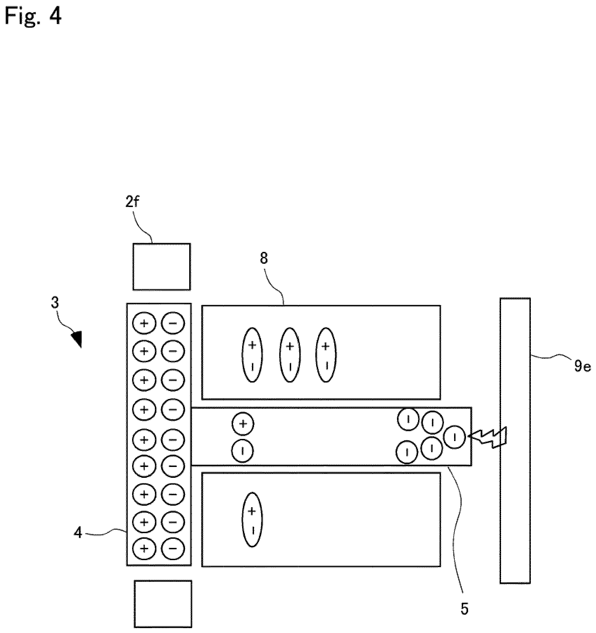

Principle that electric charges are discharged from the tip of the rotary axis 5 to the discharged section 9e is described. Fig. 4 is a schematic diagram illustrating the volume knob 3, the rotary encoder 8, and the discharged section 9e. The volume knob 3 is insulated electrically, electric charges are supplied to the volume knob 3 by discharge, and the volume knob 3 is positively (+) charged or negatively (-) charged. The rotary encoder 8 is an insulator and it is polarized in plus (+) and minus (-) by dielectric polarization. However, discharge in this route is less likely to occur. When a metal conductor (the discharged section 9e) is approached near the rotary axis 5 that is charged, induction charge that opposite polarity to charging polarity gathers occurs in the surface of the metal conductor. Especially, electric charges gather on the tip of the rotary axis 5 because the rotary diameter of the rotary axis 5 is small. In the axial direction of the rotary axis 5, by providing the discharged section 9e at a position that is separate among a predetermined distance against the tip of the rotary axis 5 and by setting a state that electric charges gather on the tip of the rotary axis 5, discharge occurs from the position that the electric field intensity is strongest in the gap of insulation. Namely, discharge can be occurred from the tip of the rotary axis 5 to the discharged section 9e. Herein, point discharge phenomenon is used.

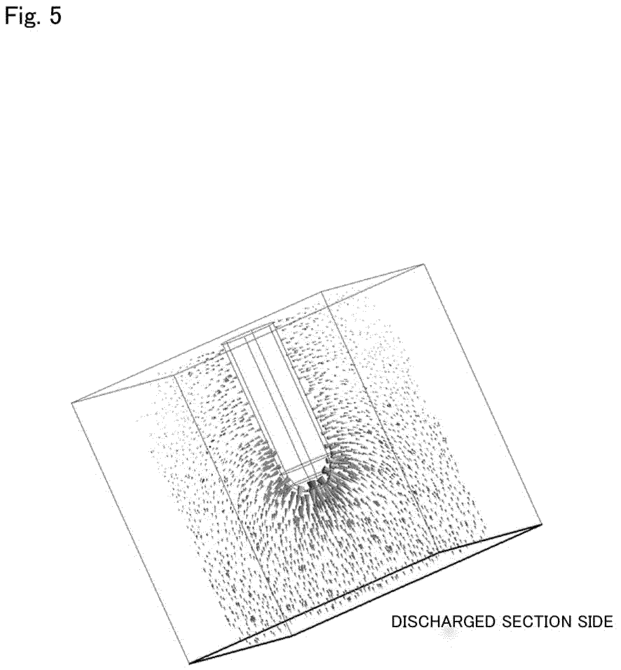

Fig. 5 is a diagram illustrating the result of a discharging test by an electromagnetic field simulator. As illustrated in Fig. 5, it is understood that the electric field gathers on the tip of the rotary axis 5.

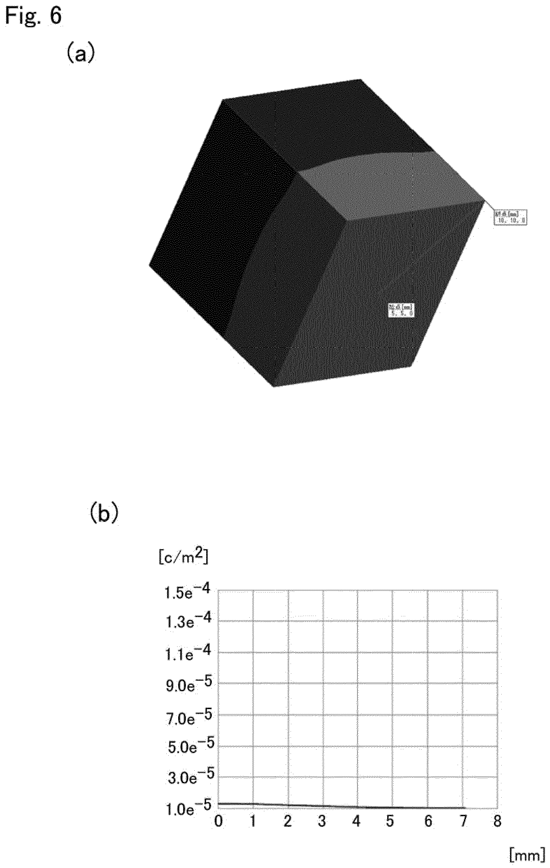

The simulation result with regard to the separate distance between the tip of the rotary axis 5 and the discharged section 9e is described below. Fig. 6 is a diagram illustrating the simulation result in case where the separate distance between the tip of the rotary axis 5 and the discharged section 9e is two times as long as the axis diameter of the rotary axis 5 (4.0 mm = 2.0 mm ×2). Fig. 6 (a) is a distribution map of the electric flux density in the discharged section 9e. Fig. 6 (b) is a graph illustrating the size of the electric flux density against the distance from the center in the discharged section 9e. As illustrated in Fig. 6, it is not clear where spark falls because the electric field is evenly spread.

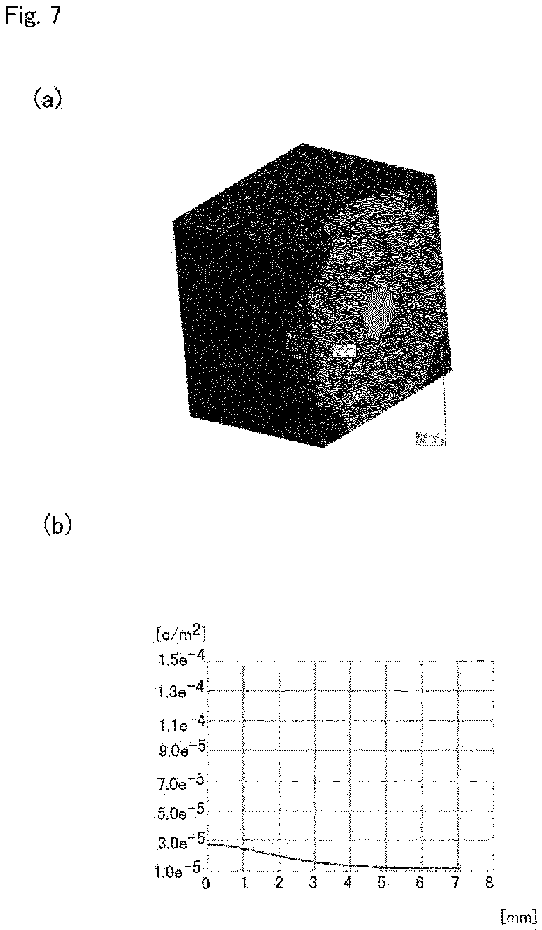

Fig. 7 is a diagram illustrating the simulation result in case where the separate distance between the tip of the rotary axis 5 and the discharged section 9e is one time as long as the axis diameter of the rotary axis 5 (2.0mm = 2.0mm × 1). Fig. 7 (a) is a distribution map of the electric flux density in the discharged section 9e. Fig. 7 (b) is a graph illustrating the size of the electric flux density against the distance from the center in the discharged section 9e. When Fig. 7 (b) is approximated to the normal distribution, 68.27% of the electric charges are within ±3mm. Further, 95.45% of electric charges are within ± 6mm.

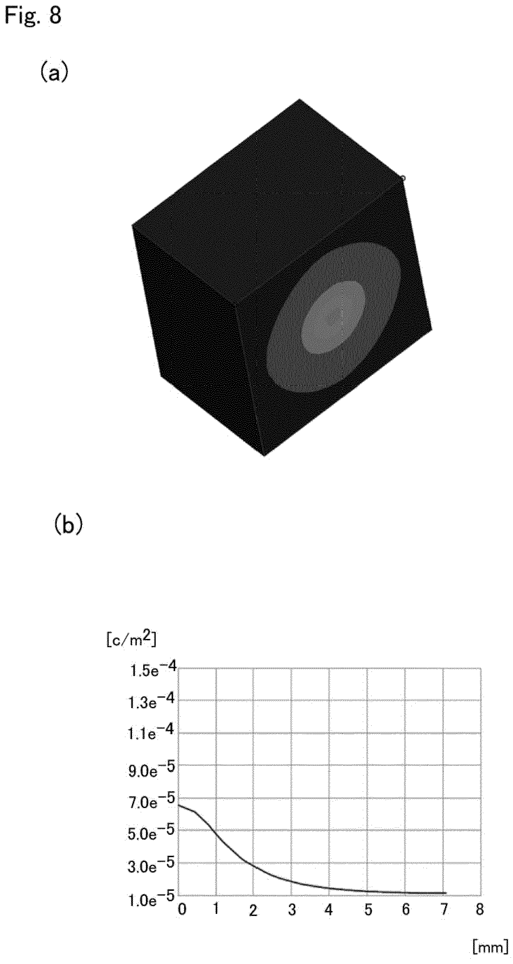

Fig. 8 is a diagram illustrating the simulation result in case where the separate distance between the tip of the rotary axis 5 and the discharged section 9e is 0.5 times as long as the axis diameter of the rotary axis 5 (1.0mm = 2.0mm × 0.5). Fig. 8 (a) is a distribution map of the electric flux density in the discharged section 9e. Fig. 8 (b) is a graph illustrating the size of the electric flux density against the distance from the center in the discharged section 9e. When Fig. 8 (b) is approximated to the normal distribution, 68.27% of electric charges are within ±1.2mm. Further, 95.45% of electric charges are within ± 2.5mm.

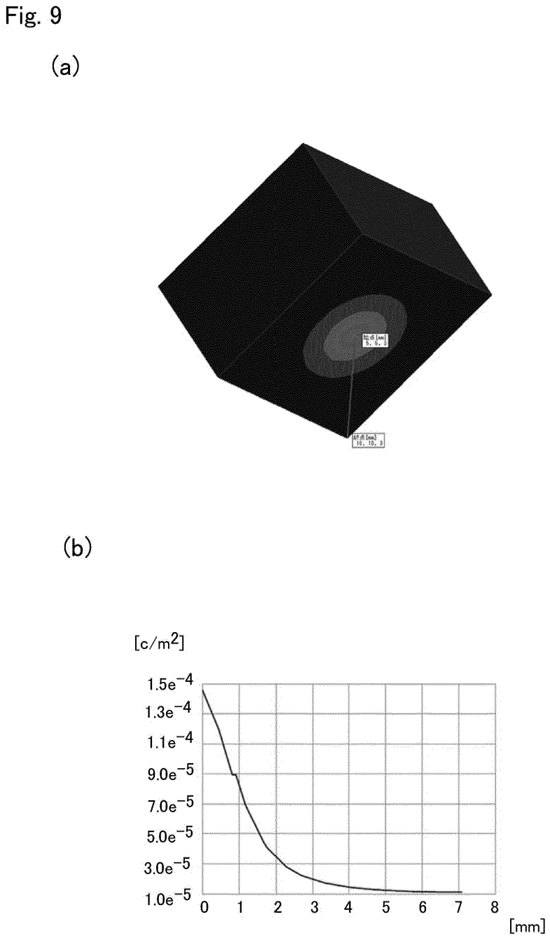

Fig. 9 is a diagram illustrating the simulation result in case where the separate distance between the tip of the rotary axis 5 and the discharged section 9e is 0.25 times as long as the axis diameter of the rotary axis 5 (0.5mm = 2.0mm × 0.25). Fig. 9 (a) is a distribution map of the electric flux density in the discharged section 9e. Fig. 9 (b) is a graph illustrating the size of the electric flux density against the distance from the center in the discharged section 9e. When Fig. 8 (b) is approximated to the normal distribution, 68.27% of electric charges are within ±0.8mm. Further, 95.45% of electric charges are within ± 1.9mm.

In this manner, in case that the separate distance between the tip of the rotary axis 5 and the discharged section 9e is 0.25 times as long as the axis diameter of the rotary axis 5 (0.5mm = 2.0mm × 0.25), electric charges gather on the center of the discharged section 9e well. For this reason, it is the most suitable that separate distance between the tip of the rotary axis 5 and the discharged section 9e is 0.25 times as long as the axis diameter of the rotary axis 5 (0.5mm = 2.0mm × 0.25).

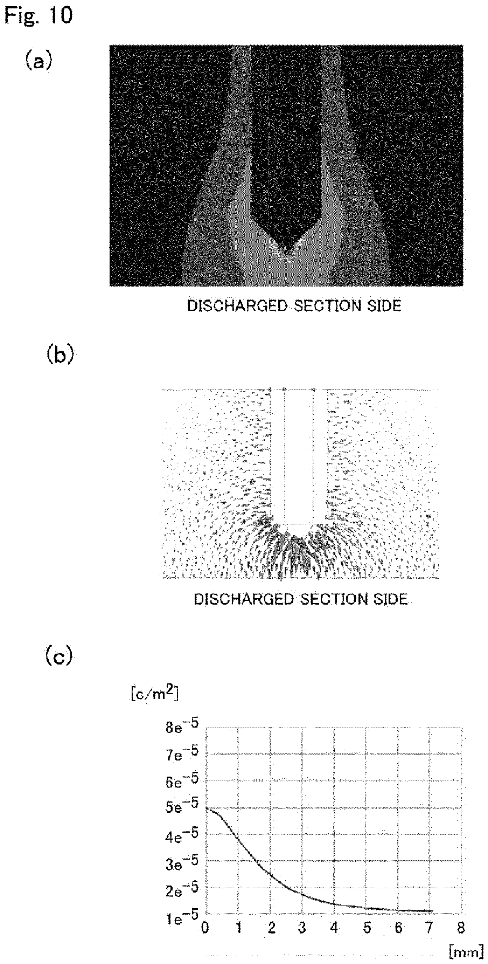

In the present embodiment, there is a problem that a discharge position is targeted within smaller range in the enclosure 2 that has small space. The simulation result with regard to the shape of the tip part of the rotary axis 5 is described below. Fig. 10 is a diagram illustrating in case where the sectional shape of the tip part of the rotary axis 5 in the axis direction of the rotary axis 5 is triangle. Fig. 10 (a) and (b) are respectively a diagram illustrating electric field between the rotary axis 5 and the discharged section 9e. Fig. 10 (c) is a diagram illustrating the size of the electric flux density in the discharged section 9e against the distance from the center. As illustrated in Fig. 10 (a) and (b), the electric field of the rotary axis 5 side gathers on the tip of the rotary axis 5 (pointed tip part). For this reason, it is highly possible that discharge occurs at one position. However, dielectric of the discharged section 9e is little and the strength that attracts static electricity is weak because the discharged section 9e that the rotary axis 5 faces is plane. For this reason, as illustrated in Fig. 10 (c), the electric charge distribution is gentle from the center of the discharged section 9e and a discharge range is wide. Therefore, in the present embodiment, this shape is not suitable.

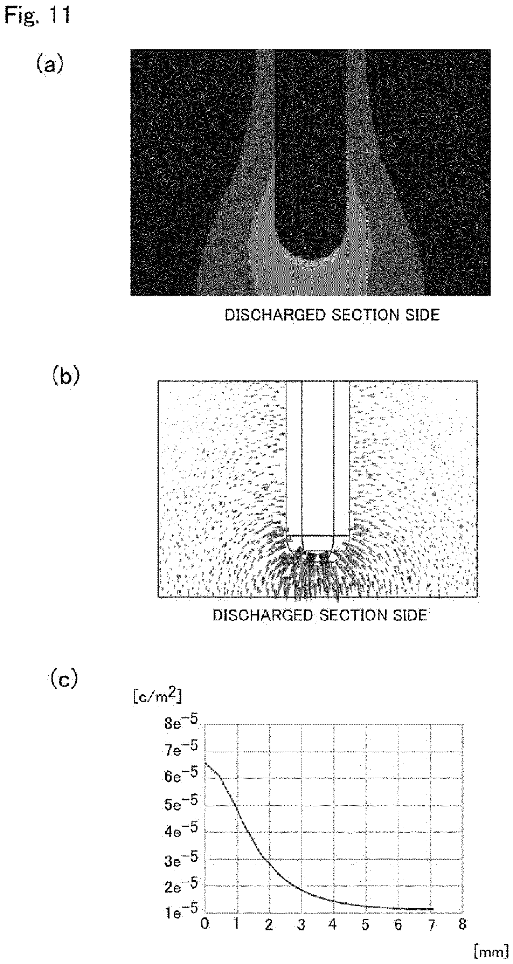

Fig. 11 is a diagram illustrating the simulation result in case where the sectional shape of the tip part of the rotary axis 5 in the axis direction is substantially semicircle. Fig. 11 (a) and (b) are respectively a diagram illustrating electric field between the rotary axis 5 and the discharged section 9e. Fig. 11 (c) is a diagram illustrating the size of the electric flux density in the discharged section 9e against the distance from the center.

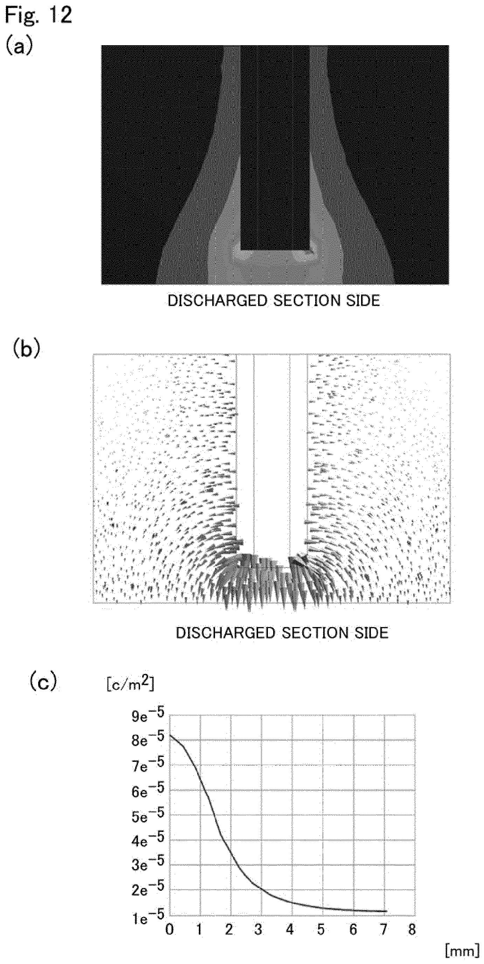

Fig. 12 is a diagram illustrating the simulation result in case where the corner part of the tip of the rotary axis 5 is right angle. Fig. 12 (a) and (b) are respectively a diagram illustrating the electric field between the rotary axis 5 and the discharged section 9e. Fig. 12 (c) is a diagram illustrating the size of the electric flux density in the discharged section 9e against the distance from the center. As illustrated in Fig. 12 (a) and (b), the electric field gathers on two positions of the corner parts. For this reason, it is possible that discharge occurs from two positions and the discharge position cannot be small range.

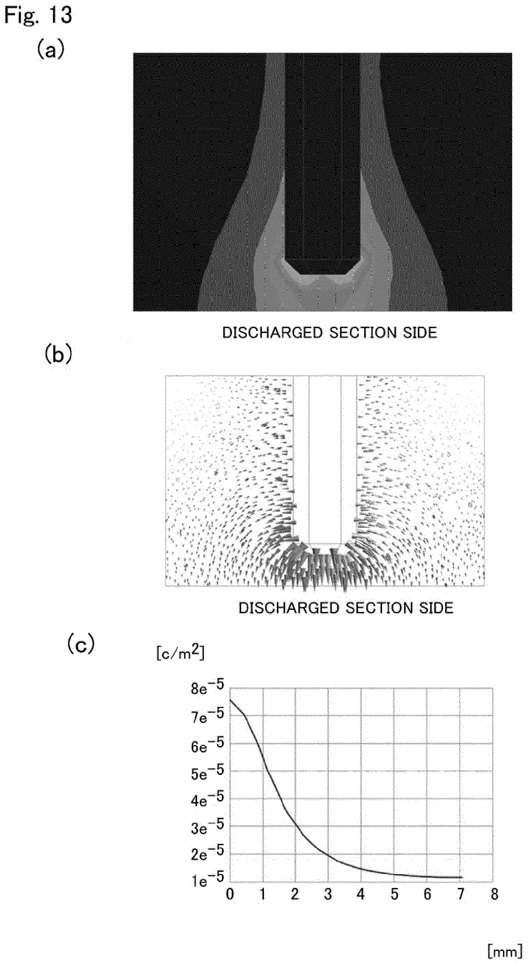

Fig. 13 is a diagram illustrating the simulation result in case where the corner part of the tip of the rotary axis 5 is tapered toward the operation tab 4. Fig. 13 (a) and (b) are respectively a diagram illustrating the electric field between the rotary axis 5 and the discharged section 9e. Fig. 13 (c) is a diagram illustrating the size of the electric flux density in the discharged section 9e against distance from the center. As illustrated in Fig. 13 (a) and (b), electric field gathers on two positions of the corner parts when it is seen sectionally in the axis direction. However, the interval between the two corner parts is small. In this manner, the corner part of the tip of the rotary axis 5 is tapered toward the operation tab 4 and the corner parts are approached to each other. Thus, it is good that the discharged position is targeted easily. Therefore, this shape is the most suitable. Further, the rotary axis 5 is inserted into the rotary encoder 8 (a bearing) easily.

As described above, in the present embodiment, the discharged section 9e made by a metal that is separate against and opposed to the tip of the rotary axis 5 of the volume knob 3 among predetermined distance in the axial direction of the rotary axis 5 is provided. Therefore, the volume knob 3 can be ground without contacting a plate spring to the volume knob 3 because discharging from the tip of the rotary axis 5 to the discharged section 9e occurs.

Further, in the present embodiment, the discharged section 9e is a part of the fitting member 9. For this reason, a new member does not need to be added for ground of the volume knob 3.

### (Second embodiment)

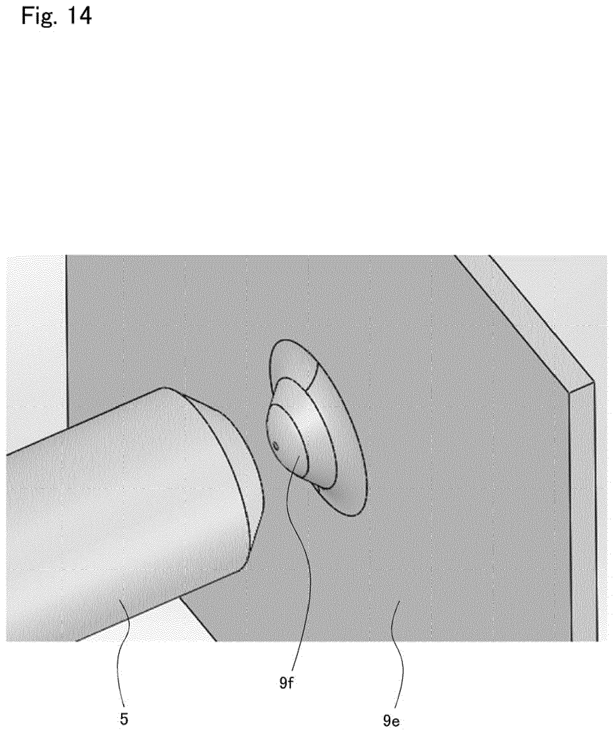

Fig. 14 is an enlarged view near the tip of the rotary encoder 5 and the discharged section 9e. As illustrated in Fig. 14, in the second embodiment, a protruding section 9f that projects against tip of the rotary axis 5 is provided in the discharged section 9e. For this reason, the electric field intensity gathers on the protruding section 9f and targeting of discharging position is further easy.

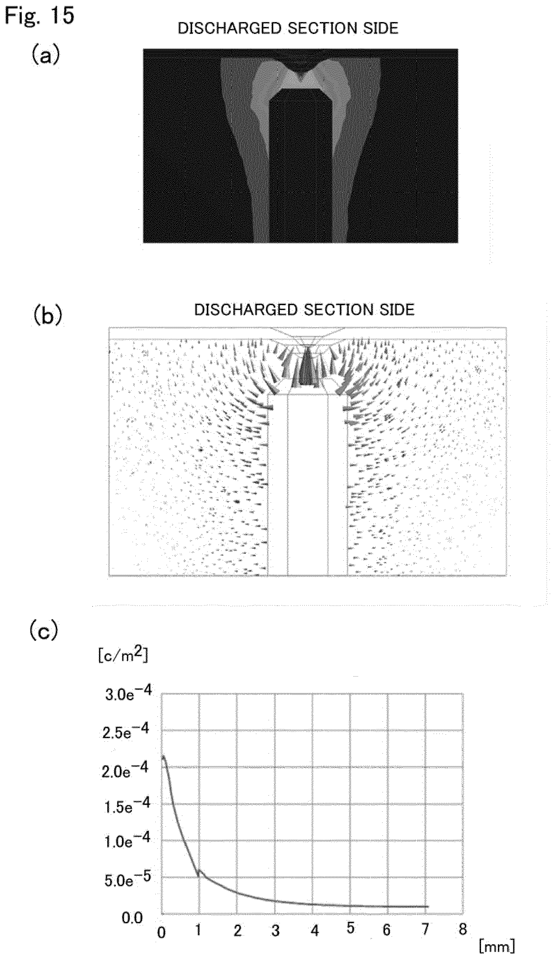

Fig. 15 is a diagram illustrating the simulation result in case where the protruding section 9f is provided in the discharged section 9e. Fig. 15 (a) and (b) are respectively a diagram illustrating the electric field between the rotary axis 5 and the discharged section 9e. Fig. 15 (c) is a diagram illustrating the size of the electric flux density in the discharged section 9e against the distance from the center. As illustrated in Fig. 15, it is understood that the discharged route gathers further.

The embodiment of the present invention is described above, but the mode to which the present invention is applicable is not limited to the above embodiment and can be suitably varied without departing from the scope of the present invention.

It is the most suitable that the corner part of the tip of the rotary axis 5 is tapered toward the operation tab 4. However, it is not limited. For example, the corner part of the tip of the rotary axis 5 may be right angle.

In the above described embodiment, as an operation knob, a volume knob for adjusting volume is exemplified. Not limited to this, the operation knob may be an operation knob for adjusting quantities.

### INDUSTRIAL APPICABILITY

The present invention can be suitably employed in an operation device that is for adjusting quantities and a music reproducing device that includes the operation device.

### DESCRIPTION OF REFFERENCE SIGNS

- 1 DAP: (music reproducing device)
- 2: enclosure
- 2a: front face
- 2b: rear face
- 2c: top face
- 2d: bottom face
- 2e: right side face
- 2f: left side face
- 3: volume knob (operation knob)
- 4: operation tab
- 5: rotary axis
- 8: rotary encoder
- 9: fitting member
- 9a, 9b: fitting section
- 9c: connecting section
- 9d: extending section
- 9e: discharged section
- 9f: protruding section
- 100: operation device

## Claims

1. An operation device (100) comprising: an operation knob (3) made by a metal that has an operation tab (4) and a rotary shaft (5) that extends vertically against the operation tab (4), wherein the operation knob (3) is insulated electrically; and
a discharged section (9e) made by a metal that is separate by a predetermined distance from and opposed to a tip of the rotary shaft (5) in an axial direction of the rotary shaft (5), wherein the discharged section (9e) is arranged such that discharging from the tip of the rotary shaft (5) to the discharged section (9e) occurs.

2. The operation device according to claim 1, wherein a corner part of the tip of the rotary shaft (5) is tapered toward the discharged section (9e).

3. The operation device according to claim 1, wherein a corner part of the tip of the rotary shaft (5) is right angle.

4. The operation device according to any one of claims 1 to 3, further comprising: a rotary encoder (8), wherein the rotary shaft (5) is inserted into a hollow shaft of the rotary encoder (8).

5. The operation device according to any one of claims 1 to 4, wherein in the axial direction of the rotary shaft (5), the tip of the rotary shaft (5) and the discharged section (9e) are separate by a distance of 0.25 times as long as the shaft diameter of the rotary shaft (5).

6. The operation device according to any one of claims 1 to 5, wherein a protruding section (9f) that projects against the tip of the rotary shaft (5) is provided in the discharged section (9e).

7. A music reproducing device (1) comprising: the operation device (100) according to any one of claims 1 to 6, wherein the operation knob (3) is a volume knob for adjusting volume.

8. The music reproducing device according to claim 7, further comprising: an enclosure (2) and parts, wherein the operation device (100) comprises a fitting member (9) that fixes the parts to the enclosure (2),
wherein the discharged section (9e) is a part of the fitting member (9).

9. The music reproducing device according to claim 8, wherein the enclosure (2) has a side face (2f) and a rear face (2b) orthogonal to the side face (2f),
the operation tab (4) exposes from the side face (2f),
the rotary shaft extends (5) parallel to the rear face (2b), and
the fitting member (9) is a tabular member and has two fitting sections (9a, 9b) that are separate from each other in a longitudinal direction of the side face (2f), a connecting section (9c) that connects the two fitting sections (9a, 9b) and orthogonal to the two fitting sections (9a, 9b), and an extending section (9d) that connects the connecting section (9c) and the discharged section (9e) and is orthogonal to the connecting section (9c) and the discharged section (9e).

## Patentansprüche

1. Bedieneinrichtung (100) umfassend:
einen aus einem Metall hergestellten Bedienknopf (3), der einen Bedienstreifen (4) und einen Drehschaft (5), der sich vertikal gegen den Bedienstreifen (4) erstreckt, aufweist, wobei der Bedienknopf (3) elektrisch isoliert ist; und
einen aus einem Metall hergestellten entladenen Abschnitt (9e), der durch einen vorgegebenen Abstand von einer Spitze des Drehschafts (5) in einer axialen Richtung des Drehschafts beabstandet ist und ihr gegenüberliegt, wobei der entladene Abschnitt (9e) derart angeordnet ist, dass ein Entladen von der Spitze des Drehschafts (5) zu dem entladenen Abschnitt (9e) auftritt.

2. Bedieneinrichtung gemäß Anspruch 1, wobei sich ein Eckabschnitt der Spitze des Drehschafts (5) in Richtung des entladenen Abschnitts (9e) verjüngt.

3. Bedieneinrichtung gemäß Anspruch 1, wobei ein Eckabschnitt der Spitze des Drehschafts (5) einen rechten Winkel bildet.

4. Bedieneinrichtung gemäß einem der Ansprüche 1 bis 3, ferner umfassend:
einen Drehwertgeber (8), wobei der Drehschaft (5) in einen hohlen Schaft des Drehwertgebers (8) eingeführt ist.

5. Bedieneinrichtung gemäß einem der Ansprüche 1 bis 4, wobei in der axialen Richtung des Drehschafts (5) die Spitze des Drehschafts (5) und der entladene Abschnitt (9e) durch einen Abstand getrennt sind, der von 0,25-mal so lang wie ein Schaftdurchmesser des Drehschafts (5) ist.

6. Bedieneinrichtung gemäß einem der Ansprüche 1 bis 5, wobei ein vorstehender Abschnitt (9f), der gegen die Spitze des Drehschafts (5) vorsteht, in dem entladenen Abschnitt (9e) vorgesehen ist.

7. Musikwiedergabevorrichtung (1), umfassend:
die Bedieneinrichtung (100) gemäß einem der Ansprüche 1 bis 6, wobei der Bedienknopf (3) ein Lautstärkeknopf zum Einstellen der Lautstärke ist.

8. Musikwiedergabevorrichtung gemäß Anspruch 7, welche ferner aufweist:
eine Einfassung (2) und Teile, wobei die Bedieneinrichtung (100) ein Einpasselement (9) aufweist, welches die Teile an der Einfassung (2) fixiert, wobei der entladene Abschnitt (9e) ein Teil des Einpasselements (9) ist.

9. Musikwiedergabevorrichtung gemäß Anspruch 8, wobei
die Einfassung (2) eine Seitenfläche (2f) und eine hintere Fläche (2b) aufweist, die senkrecht zu der Seitenfläche (2f) ist,
der Bedienstreifen (4) in der Seitenfläche (2f) freiliegt,
der Drehschaft (5) sich parallel zu der hinteren Fläche (2b) erstreckt, und
das Einpasselement (9) ein flaches Element ist und zwei Einpassabschnitte (9a, 9b), die voneinander in einer longitudinalen Richtung der Seitenfläche (2f) getrennt sind, ein Verbindungsabschnitt (9c), der die zwei Einpassabschnitte (9a, 9b) verbindet und der senkrecht zu den zwei Einpassabschnitten (9a, 9b) ist, und einen sich erstreckenden Abschnitt (9d) aufweist, der den Verbindungsabschnitt (9c) und den entladenen Abschnitt (9e) verbindet und der senkrecht zu dem Verbindungsabschnitt (9c) und dem entladenen Abschnitt (9e) ist.

## Revendications

1. Dispositif de commande (100), comprenant : un bouton de commande (3) constitué d'un métal, comportant une molette de commande (4) et un axe rotatif (5) qui s'étend verticalement par rapport à la molette de commande (4), dans lequel le bouton de commande (3) est électriquement isolé ; et
une section de décharge (9e) constituée d'un métal, espacée d'une distance prédéterminée d'une extrémité de l'axe rotatif (5), et située en regard de cette dernière, dans une direction axiale de l'axe rotatif (5), dans lequel la section de décharge (9e) est disposée de façon à donner lieu à une décharge de l'extrémité de l'axe rotatif (5) vers la section de décharge (9e).

2. Dispositif de commande selon la revendication 1, dans lequel une partie de coin de l'extrémité de l'axe rotatif (5) est biseautée en direction de la section de décharge (9e).

3. Dispositif de commande selon la revendication 1, dans lequel une partie de coin de l'extrémité de l'axe rotatif (5) forme un angle droit.

4. Dispositif de commande selon l'une quelconque des revendications 1 à 3, comprenant en outre : un codeur rotatif (8), dans lequel l'axe rotatif (5) est introduit dans un axe creux du codeur rotatif (8).

5. Dispositif de commande selon l'une quelconque des revendications 1 à 4, dans lequel, dans la direction axiale de l'axe rotatif (5), l'extrémité de l'axe rotatif (5) et la section de décharge (9e) sont séparées d'une distance correspondant à 0,25 fois la mesure du diamètre d'axe de l'axe rotatif (5).

6. Dispositif de commande selon l'une quelconque des revendications 1 à 5, dans lequel une section en saillie (9f) faisant saillie en direction de l'extrémité de l'axe rotatif (5) est disposée dans la section de décharge (9e).

7. Dispositif de reproduction de musique (1), comprenant : le dispositif de commande (100) selon l'une quelconque des revendications 1 à 6, dans lequel le bouton de commande (3) est un bouton de volume permettant de régler le volume.

8. Dispositif de reproduction de musique selon la revendication 7, comprenant en outre : une enceinte (2) et des pièces, dans lequel le dispositif de commande (100) comprend un élément de montage (9) qui fixe les pièces à l'enceinte (2),
dans lequel la section de décharge (9e) fait partie de l'élément de montage (9).

9. Dispositif de reproduction de musique selon la revendication 8, dans lequel l'enceinte (2) comporte une face latérale (2f) et une face arrière (2b) orthogonale à la face latérale (2f),
la molette de commande (4) est accessible depuis la face latérale (2f),
l'axe rotatif (5) s'étend parallèlement à la face arrière (2b), et
l'élément de montage (9) est un élément tabulaire et comporte deux sections de montage (9a, 9b) séparées l'une de l'autre dans une direction longitudinale de la face latérale (2f), une section de liaison (9c) qui relie les deux sections de montage (9a, 9b) et qui est orthogonale aux deux sections de montage (9a, 9b), et une section de prolongement (9d) qui relie la section de liaison (9c) et la section de décharge (9e) et qui est orthogonale à la section de liaison (9c) et à la section de décharge(9e).
